# EUROPÄISCHE PATENTSCHRIFT

(11) **EP 2 201 685 B1**
(45) Veröffentlichungstag und Bekanntmachung des Hinweises auf die Patenterteilung: **13.04.2011**
(21) Anmeldenummer: 08803697.5
(22) Anmeldetag: 05.09.2008
(51) Int. Cl.: H03K 17/96

(54) **KAPAZITIVER ANNÄHERUNGS- UND/ODER BERÜHRUNGSSCHALTER**
CAPACITIVE PROXIMITY AND/OR TOUCH SWITCH
COMMUTATEUR CAPACITIF À EFFLEUREMENT ET/OU À DÉTECTION DE PROXIMITÉ

(30) Priorität: 18.09.2007 DE 102007044393
(43) Veröffentlichungstag der Anmeldung: 30.06.2010
(73) Patentinhaber: BSH Bosch und Siemens Hausgeräte GmbH, 81739 München (DE)
(72) Erfinder: REINKER, Bernward Maria, 93128 Regenstauf (DE)
(86) Internationale Anmeldenummer: PCT/EP2008/061727
(87) Internationale Veröffentlichungsnummer: WO 2009/037131

(56) Entgegenhaltungen:
- EP-A- 0 859 467
- EP-A- 1 257 057
- EP-A- 1 376 872
- DE-A1- 10 352 681

## Beschreibung

Die Erfindung bezieht sich auf einen kapazitiver Annäherungs- und/oder Berührungsschalter, mit einem elektrisch leitfähigen Körper, der den Abstand zwischen einer zumindest teilweise lichtdurchlässigen, elektrisch isolierenden Abdeckplatte und einer Trägerplatte überbrückt, wobei der elektrisch leitfähige Körper an seinem der Abdeckplatte zugewandten Ende eine Sensorfläche aufweist, die über den elektrisch leitenden Körper mit einer Auswerteschaltung verbunden ist, und wobei der Sensorfläche eine Lichtquelle zugeordnet ist, durch deren Licht in einem an der Vorderseite der Abdeckplatte durch die Sensorfläche definierten Bedienbereich eine optische Anzeige realisiert ist.

Ein solcher kapazitiver Annäherungs- oder Berührungsschalter ist bereits aus EP 0 859 467 B1 bekannt. Dort überbrückt ein elektrisch leitfähiger Kunststoffkörper den Abstand zwischen einer Leiterplatte und der Glaskeramikplatte eines Kochfeldes. Die Fläche, mit der der Kunststoffkörper an der Unterseite der Glaskeramikplatte anliegt, bildet die Sensorfläche. Mit seinem anderen Ende liegt der Kunststoffkörper an einer elektrischen Kontaktfläche der Leiterplatte an. Insbesondere kann dieser Kunststoffkörper einen zentralen Durchbruch aufweisen, in welchem eine Leuchtdiode angeordnet ist. Diese LED markiert den an der Oberseite der Glaskeramikplatte durch die Sensorfläche definierten Bedienbereich optisch, indem sie beispielsweise permanent leuchtet oder Schaltzustände durch Leuchtzeichen angibt.

In DE 696 02 161 T2 ist als elektrisch leitfähiger Körper eine Blattfeder vorgesehen, die in Form eines Z gebogen ist. Diese Blattfeder besteht aus einer Grundplatte, die auf der Trägerplatte befestigt ist und einer oberen Platte, die gegen die Unterseite der parallel zur Trägerplatte angeordneten Abdeckplatte gedrückt werden kann und dort die Sensorfläche bildet. Die Grundplatte und die obere Platte bilden die beiden Enden des Z, die durch ein mittleres, schräges Teil des Z miteinander verbunden sind. Durch dieses schräge Teil wird der Blattfeder derartig Flexibilität verliehen, dass Abweichungen in der Parallelität zwischen Trägerplatte und Abdeckplatte durch die Blattfeder ausgeglichen werden können.

Aus Dokument EP 1 257 057 A1 ist ein Sensorelement für einen kapazitiven Berührschalter mit einer Sensorfläche, die an der Unterseite einer Bedienoberfläche anliegt, bekannt. Die Sensorfläche ist zumindest teilweise lichtdurchlässig und wird von unten mit einer auf einer beabstandeten Leiterplatte angeordneten LED als Lichtquelle angeleuchtet. Es sind trichterförmige, geschlossene Lichtleitmittel vorgesehen, die das Licht von der LED zu der Sensorfläche leiten bzw. gegen die Umgebung abschirmen. Die Lichtleitmittel können zusätzlich noch weitere Funktionen aufweisen, wie die Lagesicherung oder elektrische Kontaktierung der Sensorfläche.

Der vorliegenden Erfindung liegt die Aufgabe zugrunde, einen verbesserten kapazitiven Annäherungs- und/oder Berührungsschalter zur Verfügung zu stellen.

Die Aufgabe wird durch die Merkmale des Anspruchs 1 gelöst.

Bei einem kapazitiven Annäherungs- und/oder Berührungsschalter der eingangs genannten Art, ist eine elektrisch leitende Sensorfläche von einer zumindest teilweise lichtdurchlässigen, elektrisch isolierenden Abdeckplatte abgedeckt und bildet nach einem bekannten Prinzip eine Elektrode eines Kondensators, dessen Kapazität durch Annäherung bzw. Berührung der Abdeckplatte veränderlich ist, was mittels einer Auswerteschaltung ausgewertet werden kann. D.h. die dielektrische Abdeckplatte dient als Berühr- oder Annäherungsfläche des kapazitiven Annäherungs- und/oder Berührungsschalters, wobei ein Bedienbereich an der Oberfläche der Abdeckplatte durch die Position der Sensorfläche definiert ist. Zwischen der Abdeckplatte und einer in einem Abstand von dieser angeordneten Trägerplatte, die insbesondere eine Leiterplatte sein kann, ist ein elektrisch leitfähiger Körper angeordnet, über den die Sensorfläche mit der Auswerteschaltung verbunden ist.

Das heißt, die Bedienung des kapazitiven Annäherungs- und/oder Berührungsschalters erfolgt beispielsweise dadurch, dass ein menschlicher Finger die Abdeckplatte an der Position des Bedienbereichs berührt oder sich diesem zumindest annähert, so dass sich die Kapazität des von dem Finger und der Sensorfläche gebildeten Kondensators messbar verändert. Diese Veränderung kann durch die Auswerteschaltung detektiert werden, so dass eine Betätigung des Schalters ausgewertet bzw. umgesetzt werden kann.

Bei solch einem kapazitiven Annäherungs- und/oder Berührungsschalter, ist erfindungsgemäß eine Lichtquelle versetzt zu der Position des Bedienbereichs angeordnet, wobei der elektrisch leitfähige Körper einen Reflektorbereich aufweist, der derart ausgebildet ist, dass von der Lichtquelle abgestrahltes Licht durch den Reflektorbereich in Richtung des Bedienbereichs umlenkbar ist. Das heißt, um die Position des Bedienbereichs und/oder um Schaltzustände des Schalters für den Benutzer zu kennzeichnen, wird das von der Lichtquelle abgestrahlte Licht über den Reflektorbereich des elektrisch leitfähigen Körpers an die Position des Bedienbereichs gelenkt und durch die an dieser Position zumindest partiell lichtdurchlässigen Abdeckplatte abgestrahlt. Dabei kann sich das Licht je nach Schaltzustand unterscheiden, beispielsweise in seiner Farbe oder durch verschieden lange Leuchtsignale. Somit weist der elektrisch leitfähige Körper eine Doppelfunktion auf: Einerseits stellt er die elektrische Verbindung zwischen der im Bereich der Bedienoberfläche angeordneten Sensorfläche und einer elektrischen Auswerteschaltung her, andererseits umfasst er den Reflektorbereich, durch den seitlich eingestrahltes Licht in Richtung der Sensorfläche und damit in Richtung des Bedienbereichs umgelenkt wird, so dass der Bedienbereich benutzerfreundlich beleuchtet wird.

Bei entsprechender Formgebung des Reflektorbereichs wird das seitlich auf den elektrisch leitfähigen Körper eingestrahlte Licht entsprechend reflektiert und an die Oberfläche der Abdeckplatte in den Betätigungsbereich für den kapazitiven Annäherungs- bzw. Berührungsschalter umgelenkt. Dadurch kann auf einfache Art und Weise eine gleichmäßige Ausleuchtung des Bedienbereichs erzielt werden. Des weiteren kann eine Platzierung von elektronischen Lichtquellen innerhalb des Bereichs der Sensorfläche und somit eine Beeinflussung des Sensorsignal durch solche potenzielle Störquellen vermieden werden. Bei einem geringen Abstand zwischen der Trägerplatte und der Abdeckplatte, insbesondere wenn der Abstand für ein aktives lichtemittierendes Bauteil zu gering ist, wird nun auch eine Beleuchtung des Bedienbereichs ermöglicht, indem Licht seitlich zwischen Trägerplatte und Abdeckplatte auf den Reflektorbereich gestrahlt wird, beispielsweise über einen entsprechend dimensionierten Lichtleiter. Durch die Wahl des seitlichen Abstands von der Lichtquelle zu dem Reflektorbereich des elektrisch leitfähigen Körpers, wird die Lichtverteilung beim Auftreffen auf den Reflektorbereich festgelegt. Dadurch kann durch entsprechende Wahl dieses Abstands eine homogene Ausleuchtung des Bedienbereichs auch bei einer geringen Aufbauhöhe des Annäherungs- und/oder Berührungsschalters erzielt werden.

Vorzugsweise ist die Lichtquelle, die beispielsweise ein aktives Bauteil, wie z.B. eine Leuchtdiode oder ein passives Bauteil, wie z.B. ein Lichtleiter ist, auf der Trägerplatte angeordnet. Denkbar sind auch mehrere Lichtquellen, die insbesondere unterschiedliches Licht, in beispielsweise unterschiedlichen Farben, emittieren. Gemäß einer bevorzugten Ausführungsform ist die Lichtquelle derart ausgerichtet, dass sie ihr Licht im Wesentlichen parallel zu der Trägerplatte und/oder der Abdeckplatte abstrahlt. Das heißt, das von der Lichtquelle emittierte Licht breitet sich in dem Zwischenraum zwischen Trägerplatte und Abdeckplatte, in einer Richtung entlang der Trägerplatte und/oder der Abdeckplatte aus.

Gemäß einer weiteren Ausführungsform der Erfindung ist vorgesehen, dass zwischen der Lichtquelle und dem Reflektorbereich ein optisches Mittel angeordnet ist, um das Licht der Lichtquelle zu verändern. Insbesondere soll das Licht dabei gestreut, gefiltert, gefärbt, gebündelt oder in anderer Form in vorgebbarer Weise verändert werden. Das optische Element kann dabei ebenso wie die eigentliche Lichtquelle seitlich versetzt zu dem elektrisch leitfähigen Körper angeordnet sein und lässt sich dadurch ohne eine Erhöhung des Abstands zwischen Abdeckplatte und Trägerplatte platzsparend integrieren.

Der Reflektorbereich kann sich von der Abdeckplatte bzw. der Sensorfläche bis zu der Trägerplatte erstrecken. Dabei kann der Reflektorbereich in Form einer geschwungenen, geraden oder beliebig geformten Bahn ausgebildet sein. Vorzugsweise ist der elektrisch leitfähige Körper in Form einer 7 (sprich Sieben) ausgebildet. Dabei entspricht die Sensorfläche dem oberen Ende der 7 und der Reflektorbereich dem schrägen Teil der 7, der den Abstand zwischen der Abdeckplatte und der Trägerplatte überbrückt.

Insbesondere ist der Reflektorbereich in einem spitzen Winkel zu der Sensorfläche angeordnet. Dies führt dazu, dass Licht, das längs der Trägerplatte bzw. der Abdeckplatte bzw. der Sensorfläche von der Lichtquelle abgestrahlt wird und auf den Reflektorbereich trifft, von diesem in Richtung der Sensorfläche und damit in Richtung des Bedienbereichs umgelenkt wird.

Eine vorteilhafte Ausführungsform der Erfindung sieht weiterhin vor, dass der Reflektorbereich zur Erzeugung eines diffusen Strahlenanteils aufgeraut oder beschichtet ist. Dadurch wird das von der Lichtquelle kommende Licht gebrochen oder eingetrübt, um im Wesentlichen homogen und mit gleichmäßiger Lichtstärke den gesamten Bereich der Sensorfläche bzw. des Bedienbereichs zu beleuchten.

Bei einer weiteren vorteilhaften Ausführungsform der Erfindung weist der Reflektorbereich eine im Wesentlichen metallische Oberfläche auf, die zur gezielten Reflexion des einfallenden Lichts mit einer vorgebbaren Form ausgebildet ist. Die metallische Oberfläche dient als kostengünstiger Reflektor, wobei grundsätzlich auch jedes andere Material, welches zur Reflexion geeignet ist, verwendet werden kann. Der Reflektor kann eine vorgebbare Form einnehmen, um die Beleuchtung im Bereich der Sensorfläche bzw. des Bedienbereichs wunschgemäß gestalten zu können. Durch geeignete Formgebung kann beispielsweise das Licht einer im Wesentlichen punktförmigen Lichtquelle homogen auf die zu beleuchtende Fläche aufgeteilt werden.

Eine besonders kostengünstige Ausführungsform sieht vor, dass der elektrisch leitfähige Körper einstückig ausgebildet ist. Auf diese Weise kann die Anzahl der Bauteile des Annäherungs- und/oder Berührungsschalters minimiert werden.

In einer weiteren vorteilhaften Ausführungsform der Erfindung ist der elektrisch leitfähige Körper in Form einer Blattfeder aus elektrisch leitfähigem Material ausgebildet, von der zumindest ein Teil ihrer Oberfläche den Reflektorbereich bildet. Diese Blattfeder kann unter vorgebbarer Vorspannung gegen die Abdeckplatte und/oder die Trägerplatte drücken. Auf diese Weise kann sichergestellt werden, dass die Sensorfläche an der Rückseite der Abdeckplatte bzw. das der Abdeckplatte abgewandte Ende der Blattfeder an einer elektrischen Kontaktfläche der Trägerplatte, die insbesondere eine Leiterplatte ist, anliegt. Gleichzeitig kann die gesamte Feder als Reflektorbereich genutzt werden, um eine möglichst vollständige Umlenkung des einfallenden Lichts in Richtung auf die Sensorfläche bzw. den Bedienbereich zu ermöglichen.

Gemäß einer besonders vorteilhaften Ausführungsform ist das die Sensorfläche aufweisende Ende des elektrisch leitfähigen Körpers in Form eines Rahmens ausgebildet, und der Reflektorbereich ist zu diesem Rahmen derart angeordnet, dass das von dem Reflektorbereich umgelenkte Licht durch den Rahmen hindurchtritt. Auf diese Weise ist eine optische Anzeige innerhalb des durch die Sensorfläche definierten Bedienbereichs möglich, obwohl die Lichtquelle seitlich versetzt zu dem elektrisch leitfähigen Körper bzw. der Sensorfläche angeordnet ist.

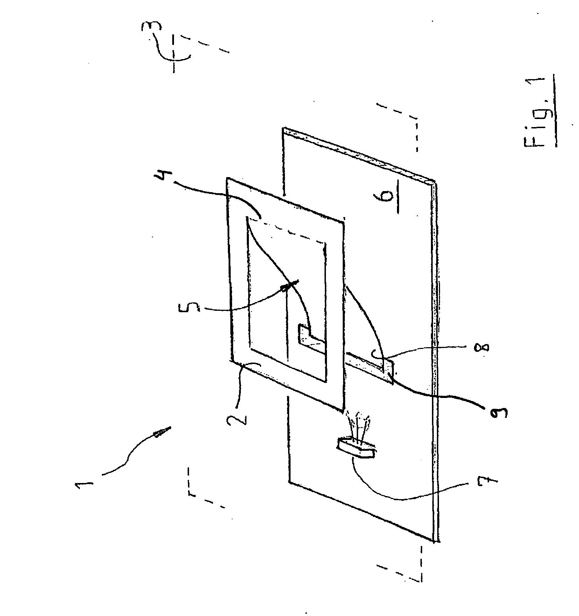

Vorzugsweise ist der elektrische Körper ein Stanzteil, wobei der Reflektorbereich von dem die Sensorfläche bestimmenden Ende weggebogen ist. Auf diese Weise kann der elektrisch leitfähige Körper aus einem ebenen Blech durch Stanzen und Biegen gefertigt werden. Beispielsweise wird er aus einem im Wesentlichen rechteckigen ebenen Element gefertigt, wobei die Sensorfläche durch die Außenkanten dieses Rechtecks bestimmt wird. In einem Stanzvorgang kann ein von der Sensorfläche umschlossenes kleineres, innen liegendes Rechteck an drei der vier Rechteckseiten von dem äußeren Rechteck, d.h. der Sensorfläche, getrennt werden, so dass die Verbindung nur noch über die vierte, nicht gestanzte Seite besteht. Dieses innen liegende Rechteck lässt sich sodann um ein Maß aus der durch die Sensorfläche definierten Ebene herausdrücken. Durch das innen liegende Rechteck wird der Abstand zwischen der Abdeckplatte und der Trägerplatte überbrückt (Fig. 1 wird dies veranschaulichen). Die Oberfläche des innen liegenden Rechtecks dient als Reflektorbereich für das von der Lichtquelle abgestrahlte Licht. Über die verbleibende gemeinsame Kante ist das innen liegende Rechteck federnd mit der Sensorfläche verbunden, so dass der elektrisch leitförmige Körper unter einer Federspannung zwischen der Abdeckplatte und der Trägerplatte montiert werden kann.

Der elektrisch leitfähige Körper kann zwischen der Abdeckplatte und der Trägerplatte auf verschiedene Weise fixiert sein. Beispielsweise wird er lediglich durch eine Klemmspannung an seiner Position fixiert. Eine andere Möglichkeit besteht darin, den elektrisch leitfähigen Körper durch seine Sensorfläche mit der Abdeckplatte zu verbinden, z. B. durch Kleben an die Rückseite der Abdeckplatte oder Einspritzen in die Abdeckplatte. Eine andere Variante sieht vor, das der Abdeckplatte abgewandte Ende des elektrisch leitfähigen Körpers an der Trägerplatte zu fixieren, z. B. durch Kleben, Löten oder Verrasten. Es ist auch möglich zwischen Abdeckplatte und Trägerplatte einen Lichtkasten anzuordnen, durch den der elektrisch leitfähige Körper in seiner vorgesehenen Position fixiert wird. Dabei können die beteiligten Bauteile Lichtkasten, Trägerplatte, Abdeckplatte und elektrisch leitfähiger Körper wiederum auf verschiedene Weisen, z. B. Kleben, Verrasten, Einspritzen etc. miteinander verbunden werden. Vorzugsweise weist der Lichtkasten Rastelemente auf, durch die er mit Gegenrastelementen der Trägerplatte und/oder der Abdeckplatte verrastet werden kann. Der elektrisch leitfähige Körper kann, beispielsweise mit seiner Sensorfläche auf dem Lichtkasten aufliegen, zwischen Lichtkasten und Abdeckplatte eingeklemmt oder durch eigene Rastelemente mit Gegenrastelementen des Lichtkastens verrastet sein.

Vorzugsweise ist ein Haushaltsgerät, wie beispielsweise eine Waschmaschine, ein Wäschetrockner, eine Geschirrspülmaschine, ein Gargerät, eine Dunstabzugshaube, ein Kältegerät, ein Klimagerät, ein Warmwasserbereiter oder ein Staubsauger, bzw. ein Eingabefeld für ein Haushaltsgerät mit zumindest einem erfindungsgemäßen Annäherungs- und/oder Berührungsschalter ausgestattet. Somit kann das Haushaltsgerät mit einer das Eingabefeld umfassenden durchgängige Blende ausgestattet werden, so dass das Haushaltsgerät gegenüber einem Eintritt von Verschmutzungen oder Feuchtigkeit geschützt ist. Die Blende entspricht dabei der elektrisch isolierenden Abdeckplatte und kann beispielsweise aus Glas, Glaskeramik, Keramik, Kunststoff, Holz oder Stein gefertigt sein. Die Blende kann dabei plan oder bombiert ausgebildet sein.

Es wird darauf hingewiesen, dass die Merkmale der Unteransprüche ohne Abweichung von der erfindungsgemäßen Idee in beliebiger Weise miteinander kombinierbar sind.

Anhand von Zeichnungen wird die Erfindung nachstehend näher erläutert.
- Fig. 1: zeigt eine perspektivische und schematische Ansicht eines erfindungsgemäßen Annäherungs- und/oder Berührungsschalters,
- Fig. 2: zeigt eine schematische Seitenansicht des Schalters gemäß Figur 1 mit einem ers- ten Reflektorprofil,
- Fig. 3: zeigt eine schematische Seitenansicht des Schalters gemäß Figur 1 mit einem zwei- ten Reflektorprofil
- Fig. 4: zeigt eine schematische Seitenansicht des Schalters gemäß Figur 1 mit einem drit- ten Reflektorprofil.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungs- und/oder Berührungsschalters gemäß der Erfindung in sämtlichen Zeichnungsfiguren durch gleiche Bezugszeichen bezeichnet sind.

In Fig. 1 ist ein kapazitiver Annäherungs- und/oder Berührungsschalter 1 perspektivisch dargestellt. Der Schalter 1 umfasst dabei einen elektrisch leitfähigen Körper 4, der an seinem einer gestrichelt angedeuteten Abdeckplatte 3 zugewandten Ende eine Sensorfläche 2 aufweist. Der elektrisch leitfähige Körper 4 ist als Blattfeder in Form einer Sieben ausgebildet und erstreckt sich von der Abdeckplatte 3 bis zu einer Trägerplatte 6. An der Trägerplatte 6 liegt der elektrisch leitfähige Körper 4 mit seinem der Sensorfläche 2 abgewandten Ende 8 an einer Kontaktfläche 9 der Trägerplatte 6 an, die insbesondere eine Leiterplatte ist. Über diese Kontaktfläche 9 ist der elektrisch leitfähige Körper 4 und damit die Sensorfläche 2 mit einer Auswerteschaltung und evtl. einer nachgeordneten Gerätesteuerung elektrisch verbunden (nicht gezeigt). Der elektrisch leitfähige Körper 4 weist von der Sensorfläche 2 bis zu seinem der Sensorfläche 2 abgewandten Ende 8 einen Reflektorbereich 5 auf.

Auf der Trägerplatte 6 ist seitlich versetzt zu dem elektrisch leitfähigen Körper 4 und damit auch versetzt zu der Sensorfläche 2 eine Lichtquelle 7 angeordnet, die beispielsweise eine Leuchtdiode oder ein Ende eines Lichtleiters sein kann. Diese Lichtquelle 7 emittiert Licht, das sich entlang der Trägerplatte 6 bzw. der Abdeckplatte 3 in Richtung auf den elektrisch leitfähigen Körper 4 bzw. dessen Reflektorbereich 5 hin ausbreitet. Der Reflektorbereich 5 schließt mit der Sensorfläche 2 einen spitzen Winkel ein, so dass das Licht der Lichtquelle 7, das auf den Reflektorbereich 5 auftrifft, in Richtung der Sensorfläche 2 reflektiert, d.h. umgelenkt wird. Die Sensorfläche 2 ist in Form eines Rahmens ausgebildet, so dass das von dem Reflektorbereich 5 reflektierte Licht durch den Rahmen hindurch treten kann und somit für einen Betrachter B durch die lichtdurchlässige Abdeckplatte 3 sichtbar ist.

Der elektrisch leitfähige Körper 4 ist aus einem ebenen Blech durch Stanzen und Biegen gefertigt. In einem äußeren Rechteck liegt ein kleineres Rechteck, so dass durch die zwischen den Außenkanten beider Rechtecke liegende Fläche die rahmenförmige Sensorfläche 2 gebildet ist. Das innen liegende kleine Rechteck ist an drei der vier Rechteckseiten von dem äußeren Rechteck getrennt und aus der von der Sensorfläche 2 gebildeten Ebene heraus gebogen. Dieses innen liegende kleine Rechteck überbrückt den Abstand zwischen der Abdeckplatte 3 und der Trägerplatte 6 und bildet den Reflektorbereich 5 des elektrisch leitfähigen Körpers 4.

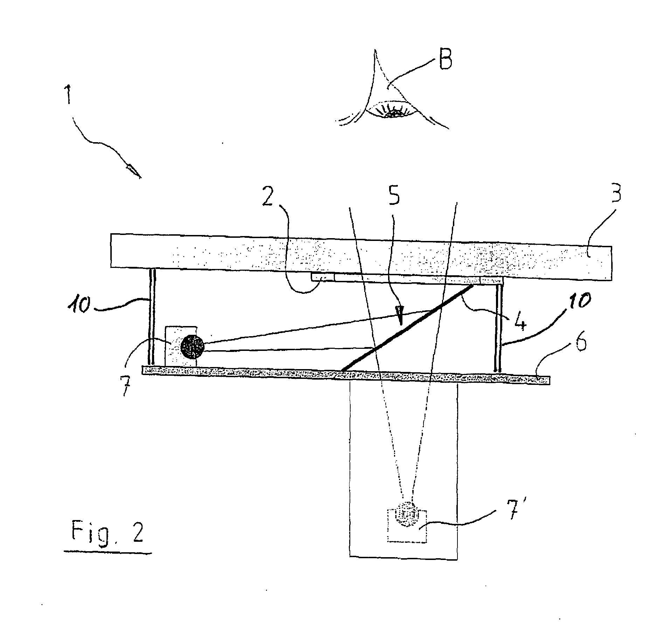

Fig. 2 erläutert die Lichtverhältnisse bei dem Annäherungs- und/oder Berührungsschalter gemäß Figur 1. Das von der Lichtquelle 7 seitlich in Richtung auf den Reflektorbereich 5 eingestrahlte Licht wird von diesem in Richtung zur Bedienoberfläche 3 reflektiert und ist, da die Abdeckplatte 3 zumindest im Bereich der Sensorfläche 2 lichtdurchlässig ausgebildet ist, durch einen Beobachter B entsprechend wahrnehmbar. Da der Weg, den das Licht von der Lichtquelle 7 über den Reflektorbereich 5 bis zu der Abdeckplatte 3 zurücklegt größer ist als der Abstand zwischen Trägerplatte 6 und Abdeckplatte 3, wird für der Beobachter B eine vergleichbare Lichtverteilung erzielt, wie bei einer virtuellen Lichtquelle 7', die in einer geraden Verlängerung von der Sensorfläche 2 zu der Trägerplatte unterhalb der Trägerplatte 6 angeordnet wäre. Durch die Wahl des seitliche Abstandes der Lichtquelle 7 zu dem Reflektorbereich 5 kann die Lichtverteilung entsprechend verändert werden, während gleichzeitig eine geringe Bauhöhe des Annäherungs- und/oder Berührungsschalters 1 möglich ist.

Damit die Lichtemission auf den Bedienbereich des Annäherungs- und/oder Berührungsschalter 1 beschränkt bleibt, ist ein Lichtkasten 10 vorgesehen, der den elektrisch leitfähigen Körper 4 und die Lichtquelle 7 umgibt. Auf diese Weise ist das von der Lichtquelle 7 emittierte Licht in seiner Ausdehnung auf den Lichtkasten 10 beschränkt. Gleichzeitig dient der Lichtkasten 10 dazu, den elektrisch leitfähigen Körper 4 in seiner Position an der Rückseite der Abdeckplatte 3 zu fixieren. Der elektrisch leitfähige Körper 4 liegt mit seiner Sensorfläche 2 auf dem Lichtkasten 10 auf und wird durch diesen an die Rückseite der Abdeckplatte 3 gedrückt.

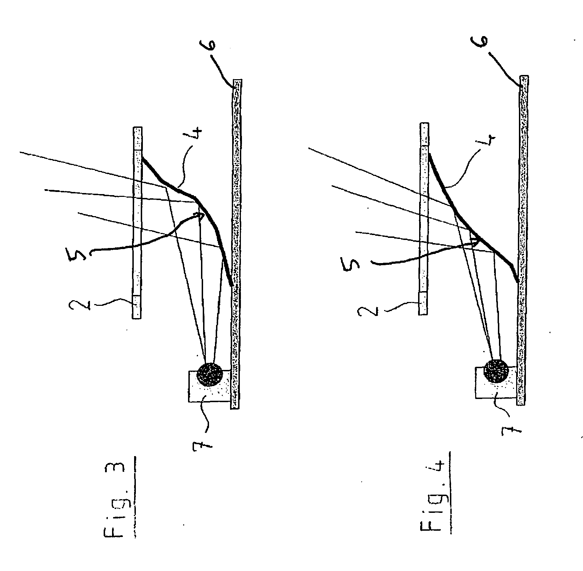

Die Figuren 3 und 4 zeigen anhand unterschiedlich geformter Reflektorbereiche 5 die Möglichkeit, das von der Lichtquelle 7 ausgehende Licht wählbar umzulenken, um unterschiedliche optische Eindrücke hervorzurufen. In Figur 3 ist der Reflektorbereich 5 in Bezug auf die Sensorfläche 2 konvex gewölbt, so dass das von dem Reflektorbereich reflektierte Licht gebündelt wird. In Figur 4 ist der Reflektorbereich 5 in Bezug auf die Sensorfläche konkav gewölbt, wodurch der gegenteilige Effekt erzielt wird, d.h. das reflektierte Licht wird zerstreut.

### Bezugszeichenliste

- 1: kapazitiver Annäherungs- und/oder Berührungsschalter
- 2: Sensorfläche
- 3: Abdeckplatte
- 4: elektrisch leitfähiger Körper
- 5: Reflektorbereich
- 6: Trägerplatte
- 7: Lichtquelle
- 8: Ende des elektrisch leitfähigen Körpers, das der Abdeckplatte abgewandt ist
- 9: Kontaktfläche der Trägerplatte
- 10: Lichtkasten
- B: Beobachter

## Patentansprüche

1. Kapazitiver Annäherungs- und/oder Berührungsschalter, mit einem elektrisch leitfähigen Körper (4), der den Abstand zwischen einer zumindest teilweise lichtdurchlässigen, elektrisch isolierenden Abdeckplatte (3) und einer Trägerplatte (6) überbrückt, wobei der elektrisch leitfähige Körper (4) an seinem der Abdeckplatte (3) zugewandten Ende eine Sensorfläche (2) aufweist, die über den elektrisch leitfähigen Körper (4) mit einer Auswerteschaltung verbunden ist, und wobei der Sensorfläche (2) eine Lichtquelle (7) zugeordnet ist, durch deren Licht in einem an der Vorderseite der Abdeckplatte (3) durch die Sensorfläche (2) definierten Bedienbereich eine optische Anzeige realisiert ist, **dadurch gekennzeichnet, dass** die Lichtquelle (7) versetzt zu der Position des Bedienbereichs angeordnet ist, dass die Lichtquelle (7) derart angeordnet ist, dass ihr Licht längs der Trägerplatte (6) und/oder der Abdeckplatte (3) abgestrahlt wird, und dass der elektrisch leitfähige Körper (4) einen Reflektorbereich (5) aufweist, der derart ausgebildet ist, dass von der Lichtquelle (7) seitlich eingestrahltes Licht durch den Reflektorbereich (5) in Richtung des Bedienbereichs umgelenkt wird.

2. Schalter nach Anspruch 1, **dadurch gekennzeichnet, dass** die Lichtquelle (7) auf der Trägerplatte (6) angeordnet ist.

3. Schalter nach Anspruch 1 oder 2, **dadurch gekennzeichnet, dass** zwischen der Lichtquelle (7) und dem Reflektorbereich (5) ein optisches Mittel angeordnet ist, durch das das Licht der Lichtquelle (7) verändert wird, insbesondere gestreut, gefiltert, eingefärbt oder gebündelt.

4. Schalter nach einem der vorhergehenden Ansprüche, **dadurch gekennzeichnet, dass** sich der Reflektorbereich (5) von der Abdeckplatte (3) bis zu der Trägerplatte (6) erstreckt.

5. Schalter nach einem der vorhergehenden Ansprüche, **dadurch gekennzeichnet, dass** der Reflektorbereich (5) in einem spitzen Winkel zu der Sensorfläche (2) angeordnet ist.

6. Schalter nach einem der vorhergehenden Ansprüche, **dadurch gekennzeichnet, dass** der Reflektorbereich (5) zur Erzeugung eines diffusen Strahlenanteils aufgeraut oder beschichtet ist.

7. Schalter nach einem der vorhergehenden Ansprüche, **dadurch gekennzeichnet, dass** der Reflektorbereich (5) eine metallische Oberfläche aufweist, die zur gezielten Reflexion des einfallenden Lichts mit einer vorgebbaren Form ausgebildet ist.

8. Schalter nach einem der vorhergehenden Ansprüche, **dadurch gekennzeichnet, dass** der elektrisch leitfähige Körper (4) einstückig ausgebildet ist.

9. Schalter nach einem der vorhergehenden Ansprüche, **dadurch gekennzeichnet, dass** der elektrisch leitfähige Körper (4) eine Blattfeder aus elektrisch leitfähigem Material ist, von der zumindest ein Teil der Oberfläche den Reflektorbereich (5) bildet.

10. Schalter nach einem der vorhergehenden Ansprüche, **dadurch gekennzeichnet, dass** das die Sensorfläche (2) aufweisende Ende des elektrisch leitfähigen Körpers (4) in Form eines Rahmens ausgebildet ist, und dass der Reflektorbereich (5) zu diesem Rahmen derart angeordnet ist, dass das von dem Reflektorbereich (5) umgelenkte Licht durch den Rahmen hindurchtritt.

11. Schalter nach einem der vorhergehenden Ansprüche, **dadurch gekennzeichnet, dass** der elektrische Körper (4) ein Stanzteil ist, und dass der Reflektorbereich (5) von dem die Sensorfläche (2) bestimmenden Ende weggebogen ist.

12. Schalter nach einem der vorhergehenden Ansprüche, **dadurch gekennzeichnet, dass** der elektrisch leitfähige Körper (4) mit seinem die Sensorfläche (2) bestimmenden Ende an der Rückseite der Abdeckplatte (3) anliegt oder in die Abdeckplatte (3) integriert ist.

13. Haushaltsgerät mit einem Schalter (1) nach einem der Ansprüche 1 bis 12.

14. Elektrisch leitfähiger Körper (4) für einen Schalter (1) nach einem der Ansprüche 1 bis 12.

## Claims

1. Capacitive proximity and/or touch switch, comprising an electrically conductive body (4) bridging over the spacing between an at least partly light-permeable, electrically insulating cover plate (3) and a support plate (6), wherein the electrically conductive body (4) has at its end facing the cover plate (3) a sensor surface (2) connected with an evaluating circuit by way of the electrically conductive body (4) and wherein associated with the sensor surface (2) is a light source (7), through the light of which an optical indication is realised in a control region defined at the front side of the cover plate (3) by the sensor surface (2), **characterised in that** the light source (7) is arranged offset relative to the position of the control region, that the light source (7) is arranged in such a manner that the light thereof is radiated longitudinally of the support plate (6) and/or the cover plate (3) and that the electrically conductive body (4) has a reflector region (5) so constructed that light laterally radiated in by the light source (7) is deflected by the reflector region (5) in the direction of the control region.

2. Switch according to claim 1, **characterised in that** the light source (7) is arranged on the support plate (6).

3. Switch according to claim 1 or 2, **characterised in that** an optical means by which the light of the light source (7) is changed, in particular diffused, filtered, coloured or focused, is arranged between the light source (7) and the reflector region (5).

4. Switch according to any one of the preceding claims, **characterised in that** the reflector region (5) extends from the cover plate (3) to the support plate (6).

5. Switch according to any one of the preceding claims, **characterised in that** the reflector region (5) is arranged at an acute angle to the sensor surface (2).

6. Switch according to any one of the preceding claims, **characterised in that** the reflector region (5) is roughened or coated for generating a diffuse beam component.

7. Switch according to any one of the preceding claims, **characterised in that** the reflector region (5) has a metallic surface which is constructed with a predeterminable shape for selective reflection of the incident light.

8. Switch according to any one of the preceding claims, **characterised in that** the electrically conductive body (4) is of integral construction.

9. Switch according to any one of the preceding claims, **characterised in that** the electrically conductive body (4) is a leaf spring of electrically conductive material, of which at least a part forms the surface of the reflector region (5).

10. Switch according to any one of the preceding claims, **characterised in that** the end of the electrically conductive body (4) having the sensor surface (2) is constructed in the form of a frame and that the reflector region (5) is so arranged with respect to this frame that the light deflected by the reflector region (5) passes through the frame.

11. Switch according to any one of the preceding claims, **characterised in that** the electrical body (4) is a punched part and that the reflector region (5) is bent away from the end determining the sensor surface (2).

12. Switch according to any one of the preceding claims, **characterised in that** the electrically conductive body (4) by its end determining the sensor surface (2) bears against the rear side of the cover plate (3) or is integrated in the cover plate (3).

13. Domestic appliance with a switch (1) according to any one of claims 1 to 12.

14. Electrically conductive body (4) for a switch (1) according to any one of claims 1 to 12.

## Revendications

1. Commutateur capacitif à détection de proximité et/ou à effleurement, comprenant un corps électroconducteur (4) qui franchit la distance entre une plaque de protection electroisolante (3) au moins partiellement translucide et une plaque de support (6), ledit corps électroconducteur (4) présentant à son extrémité tournée vers la plaque de support (3) une surface de détection (2), reliée via le corps électroconducteur (4) à un circuit d'interprétation, et à ladite surface de détection (2) étant associée une source lumineuse (7), par la lumière de laquelle un affichage optique est réalisé dans une zone de commande définie par la surface de détection (2) sur la face avant de la plaque de protection (3), **caractérisé en ce que** la source lumineuse (7) est disposée de façon décalée par rapport à la position de la zone de commande, **en ce que** la source lumineuse (7) est disposée de telle façon que sa lumière est diffusée le long de la plaque de support (6) et/ou de la plaque de protection (3), et **en ce que** le corps électroconducteur (4) présente une zone de réflexion (5) laquelle est conçue de telle façon que la lumière émise latéralement par la source lumineuse (7) est redirigée par la zone de réflexion (5) en direction de la zone de commande.

2. Commutateur selon la revendication 1, **caractérisé en ce que** la source lumineuse (7) est disposée sur la plaque de support (6).

3. Commutateur selon la revendication 1 ou 2, **caractérisé en ce qu'**un moyen optique est disposé entre la source lumineuse (7) et la zone de réflexion (5), par lequel la lumière de la source lumineuse (7) est modifiée, notamment dispersée, filtrée, colorée ou concentrée.

4. Commutateur selon l'une des revendications précédentes, **caractérisé en ce que** la zone de réflexion (5) s'étend de la plaque de protection (3) jusqu'à la plaque de support (6).

5. Commutateur selon l'une des revendications précédentes, **caractérisé en ce que** la zone de réflexion (5) est disposée selon un angle aigu par rapport à la surface de détection (2).

6. Commutateur selon l'une des revendications précédentes, **caractérisé en ce que** la zone de réflexion (5) est rendue rugueuse ou est dotée d'un revêtement pour produire une fraction de rayonnement diffus.

7. Commutateur selon l'une des revendications précédentes, **caractérisé en ce que** la zone de réflexion (5) présente une surface métallique réalisée dans une forme prédéfinissable pour la réflexion ciblée de la lumière incidente.

8. Commutateur selon l'une des revendications précédentes, **caractérisé en ce que** le corps électroconducteur (4) est réalisé en une pièce.

9. Commutateur selon l'une des revendications précédentes, **caractérisé en ce que** le corps électroconducteur (4) est un ressort à lames en matériau électroconducteur, dont au moins une partie de la surface forme la zone de réflexion (5).

10. Commutateur selon l'une des revendications précédentes, **caractérisé en ce que** l'extrémité du corps électroconducteur (4) présentant la surface de détection (2) est réalisée sous forme d'un cadre, et **en ce que** la zone de réflexion (5) est disposée de telle façon par rapport à ce cadre que la lumière redirigée par la zone de réflexion (5) passe à travers le cadre.

11. Commutateur selon l'une des revendications précédentes, **caractérisé en ce que** le corps électrique (4) est une pièce découpée, et **en ce que** la zone de réflexion (5) est repliée par rapport à l'extrémité définissant la surface de détection (2).

12. Commutateur selon l'une des revendications précédentes, **caractérisé en ce que** le corps électroconducteur (4), avec son extrémité définissant la surface de détection (2), s'appuie contre la face arrière de la plaque de protection (3) ou est intégré dans la plaque de protection (3).

13. Appareil ménager doté d'un commutateur (1) selon l'une des revendications 1 à 12.

14. Corps électroconducteur (4) pour un commutateur (1) selon l'un des revendications 1 à 12.
